Europäisches Patentamt

European Patent Office

Office européen des brevets

(19)

(11) Publication number: **0 146 963 B1**

(12) **EUROPEAN PATENT SPECIFICATION**

(45) Date of publication of patent specification: **23.09.92** (51) Int. Cl.⁵: **H03H 17/04**

(21) Application number: **84116288.6**

(22) Date of filing: **24.12.84**

(54) **Iir digital filter.**

(30) Priority: **23.12.83 JP 243488/83**

(43) Date of publication of application:
**03.07.85 Bulletin 85/27**

(45) Publication of the grant of the patent:
**23.09.92 Bulletin 92/39**

(84) Designated Contracting States:
**DE FR GB NL**

(56) References cited:

**PATENT ABSTRACTS OF JAPAN, vol. 5, no. 82 (E-59)[754], 29th May 1981; & JP-A-56 30 316 (FUJITSU K.K.) 26-03-1981**

**1978 IEEE INTERNATIONAL SYMPOSIUM ON CIRCUITS AND SYSTEMS PROCEEDINGS, 17th-19th May 1978, pages 752-756, IEEE, New York, US; E. LUEDER et al.: "Equivalent sampled data filter structures and some of their properties"**

(73) Proprietor: **SONY CORPORATION**
**7-35 Kitashinagawa 6-chome Shinagawa-ku Tokyo 141(JP)**

(72) Inventor: **Yamazaki, Takao**
**c/o Sony Corporation 7-35, Kitashinagawa 6-chome**
**Shinagawa-ku Tokyo(JP)**

(74) Representative: **Schmidt-Evers, Jürgen, Dipl.-Ing. et al**
**Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10**
**W-8000 München 22(DE)**

EP 0 146 963 B1

## Description

The present invention relates to a digital filter of the infinite impulse response type according to the preamble of claim 1.

There is already known a cyclic filter ("Patent Abstracts of Japan" , Vol. 5, No. 82 (E-59) (754), 29th May 1981 and JP-A-56 30316) having the purpose of facilitating the formation by eliminating the phase difference of an output signal while eliminating the shunt of a weighting circuit and feedback circuit with the same bits, by leading a feedback signal and positive-phase addition signal out of respective stages of cascaded delay elements. An input signal is input to one-side terminals of cascaded delay circuits equal in delay time according to a transfer function. From output terminals of the first delay circuits of the cascaded delay circuits signals are fed back by way of weighting circuits with specific weighting coefficients, thereby performing addition. At output terminals of the last delay circuits of the said cascaded delay circuits signals appear and are added together in positive phase by way of weighting circuits of different weighting coefficients. Consequently, band-passing characteristics can be realized.

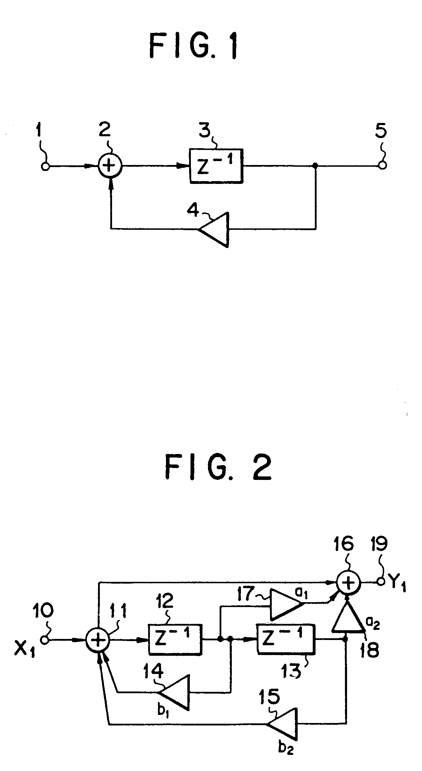

A digital filter of the infinte impulse response type, also known as IIR digital filter is a filter having sharp characteristics and lower order. The IIR digital filter has a feedback constitution as shown in Fig. 1. As clearly seen from Fig. 1, present input signal is supplied from an input terminal designated by numeral 1 to one input terminal of an adder 2, and past output signal stored in an unit delay circuit 3 is multiplied by a coefficient in a multiplying circuit 4 and then supplied to other input terminal of the adder 2, whereby the output of the adder 2 is taken through the unit delay circuit 3 to an output terminal 5.

For example, if a system function H(Z) is expressed by

$$H(Z) = \frac{1 + a_1 Z^{-1} + a_2 Z^{-2}}{1 - b_1 Z^{-1} + b_2 Z^{-2}} \quad \dots\dots\dots\dots\dots\dots (1)$$

an IIR digital filter of second order corresponding to the H(Z) is constituted as shown in Fig. 2.

In Fig. 2, input signal $x_1$ from an input terminal 10 is supplied to an adder 11. Adding output of the adder 11 is supplied to a unit delay circuit 12, and output of the unit delay circuit 12 is supplied to another unit delay circuit 13. The output of the unit delay circuit 12 is multiplied by a multiplying circuit 14 of coefficient $b_1$ and supplied to the adder 11. Output of the unit delay circuit 13 is multiplied by a multiplying circuit 15 of coefficient $b_2$ and supplied to the adder 11. Output of the adder 11 is supplied to another adder 16, and the output of the unit delay circuit 12 and the output of the unit delay circuit 13 are multiplied by a multiplying circuit 17 of coefficient $a_1$ and a multiplying circuit 18 of coefficient $a_2$ respectively, and then both multiplying outputs are supplied to the adder 16. Output of the adder 16 is supplied to an output terminal 19, and output signal $Y_1$ is taken from the output terminal 19.

As shown in Fig. 2, the IIR digital filter has feedback constitution including the multiplying circuits 14 and 15. This constitution corresponds to polynomial in denominator of expression (1).

For example, when color video signal is digitized by sampling pulse of $4f_{sc}$ ($f_{sc}$: color subscriber frequency), one sampling clock is 70 n sec. If the color video signal is processed using the IIR digital filter shown in Fig. 2, term $b_1 Z^{-1}$ including $Z^{-1}$ in the denominator must be processed by product/sum operation composed of multiplication and addition in a short time of 70 n sec. Since this processing requires time particularly for the multiplication, operation element of low speed and small consumption power, such as CMOS, cannot be used, but that of high speed and large consumption power, such as bipolar element or ECL element, can only be used.

## SUMMARY OF THE INVENTION

Accordingly, an object of the invention is to provide an IIR digital filter which can be applied to processing of color video signal or the like and use an operation element of low speed and small power, such as CMOS.

The aforementioned object is achieved by the filter set out in claim 1.

A specific embodiment of the present invention results from claim 2.

## BRIEF DESCRIPTION OF THE DRAWINGS

2

Fig. 1 is a block diagram illustrating feedback constitution required for an IIR digital filter;
Fig. 2 is a block diagram of an IIR digital filter as an example in the prior art;
Fig. 3 is a block diagram of an embodiment of the invention; and
Fig. 4 is a block diagram of an example of a multiplying circuit 25 in pipeline processing.

DESCRIPTION OF THE PREFERRED EMBODIMENT

An embodiment of the invention will now be described referring to the accompanying drawings.

For example, the system function of secod-order section of the IIR digital filter as shown in above expression (1) is

$$H(Z) = \frac{1 + a_1 Z^{-1} + a_2 Z^{-2}}{1 - b_1 Z^{-1} + b_2 Z^{-2}} \quad \cdots \cdots \cdots$$

where the denominator includes $Z^{-1}$ term. Terms in the denominator become feedback constitution as above described. Particularly, term including $Z^{-1}$ in the denominator must be processed by multiplication and addition in one clock and therefore pipeline processing cannot be executed. In order to eliminate the $Z^{-1}$ term in the denominator of the system function as shown in expression (1), the same polynomial

$(1 - b_2 Z^{-2}) + b_1 Z^{-1}$

is multiplied to both the denominator and the numerator.

$$H(Z) = \frac{1 + a_1 Z^{-1} + a_2 Z^{-2}}{1 - b_1 Z^{-1} - b_2 Z^{-2}} \times \frac{(1 - b_2 Z^{-2}) + b_1 Z^{-1}}{(1 - b_2 Z^{-2}) + b_1 Z^{-1}}$$

$$= \frac{(1 + a_1 Z^{-1} + a_2 Z^{-2})(1 + b_1 Z^{-1} - b_2 Z^{-2})}{1 - (2b_2 - b_1^2) Z^{-2} + B_2^2 Z^{-4}}$$

$$\cdots \cdots (2)$$

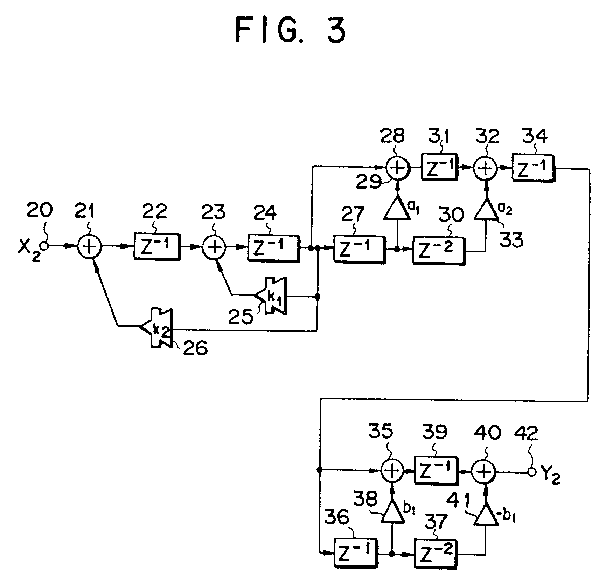

In the system function H(Z) shown in expression (2), the term including $Z^{-1}$ is eliminated from the denominator. Consequently, product/sum operation to be executed in one clock may be done during two clocks. This enables application of the pipeline processing to the product/sum operation as shown in Fig. 3.

Fig. 3 shows an IIR digital filter on the basis of expression (2), and numeral 20 in Fig. 3 designates an input terminal. Color video signal $Z_{2x}$ digitised by sampling pulse of $4f_{sc}$, for example, is supplied from the input terminal 20 to an adder 21. Adding output of the adder 21 is supplied to a unit delay circuit 22, and output of the unit delay circuit 22 is supplied to an adder 23, and further adding output of the adder 23 is supplied to a unit delay circuit 24. Output of the unit delay circuit 24 is supplied to a multiplying circuit 25 in pipeline processing and also to a multiplying circuit 26 in pipeline processing. The multiplying circuit 25 is one having a coefficient $k_1 = 2b_2 + b_1^2$, and pipeline processing in one step is executed using a register for example. The multiplying circuit 26 is one having a coefficient $k_2 = -b_2^2$, and pipeline processing in two steps is executed using a register for example. Multiplying output of the multiplying circuit 25 is supplied to the adder 23, and multiplying output of the multiplying circuit 26 is supplied to the adder 21.

The adders 21, 23, the unit delay circuit 22, 24 and the multiplying circuits 25, 26 together execute processing corresponding to the polynomial

$1 - (2b_2 + b_1^2)Z^{-2} + b_2^2 Z^{-4}$

shown in the denominator of expression (2).

Output of the unit delay circuit 24 is supplied to a unit delay circuit 27 and an adder 28. Output of the

3

unit delay circuit 27 is supplied to a multiplying circuit 29 and also to a delay circuit 30 having delay amount twice as large as the unit delay amount. The multiplying circuit 29 is one having a coefficient $a_1$. Output of the multiplying circuit 29 is supplied to the adder 28, and adding output of the adder 28 is supplied to a unit delay circuit 31, and further output of the unit delay circuit 31 is supplied to an adder 32. Output of the delay circuit 30 is supplied to a multiplier circuit 33. The multiplying circuit 33 is one having a coefficient $a_2$, and multiplying output of the multiplying circuit 33 is supplied to the adder 32. Adding output of the adder 32 is supplied to a unit delay circuit 34.

The adders 28, 32, the delay circuits 27, 30, 31, 34 and the multiplying circuits 29, 33 together execute processing corresponding to the polynomial of second order

$$(1 + a_1 Z^{-1} + a_2 Z^{-2})$$

representing the factor in the numerator of expression (2).

Output of the unit delay circuit 34 is supplied to an adder 35 and a unit delay circuit 36. Output of the unit delay circuit 36 is supplied to a delay circuit 37 having delay amount twice as large as the unit delay amount and also to a multiplying circuit 38. The multiplying circuit 38 is one having a coefficient $b_1$. Multiplying output of the multiplying circuit 38 is supplied to the adder 35, and adding output of the adder 35 is supplied to a unit delay circuit 39, and further output of the unit delay circuit 39 is supplied to an adder 40. Output of the delay circuit 37 is supplied to a multiplying circuit 41. The multiplying circuit 41 is one having a coefficient $-b_1$, and output of the multiplying circuit 41 is supplied to the adder 40.

The adders 35, 40, the delay circuits 36, 37, 39 and the multiplying circuits 38, 41 together execute processing corresponding to the polynomial of second order

$$(1 + b_1 Z^{-1} - b_2 Z^{-2})$$

representing the factor in the numerator of expression (2).

Output of the adder 40 is taken as output signal $Y_2$ from an output terminal 42.

System function in any order of an IIR digital filter can be subjected to factorization into product of system function of second order and system function of first order. Consequently, an IIR digital filter of any order can be implemented by cascade connection of a number of IIR digital filters as shown in Fig. 3.

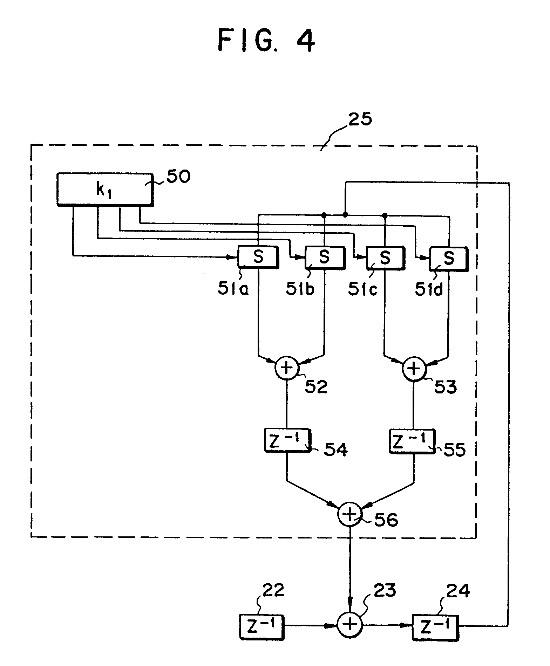

Fig. 4 shows an example of multiplying circuit 25 in pipeline processing to be used in the embodiment of Fig. 3. In the example, coefficient, i.e. digital signal $K_1$ of multiplier is input of four bits and the signal $K_1$ is multiplied to a delay circuit 24. In the example of Fig. 4, output of the unit delay circuit 24 is supplied to selectors 51a - 51d and selected by each bit signal of multiplier $k_1$ supplied to each selector. For example, when the multiplier $k_1$ is 1001, the selectors 51a, 51d are turned on and partial product signal is taken at output side thereof, and output of the selector 51a is shifted by one bit to the left and supplied to an adder 52. Output of the selector 51d is supplied to an adder 53. In usual multiplying circuit, output of the adder 52 is shifted by two bits to the left and added to an adder 56 thereby multiplying output is obtained from outputs of the adders 52, 53. In the example of Fig. 4, however, unit delay circuits 54, 55 are inserted at output side of the adders 52, 53 and pipeline processing is executed. Since the pipeline processing is executed by inserting the unit delay circuits 54, 55, select operation by the selectors 51a - 51d and adding operation by the adders 52, 53 are performed during one sample period. Adding operation by the adder 56 and the adder 23 to add output of the adder 56 and output of the delay circuit 22 may be performed during other one sample period, thereby the operation cycle time can be made 1/2. Although an adder of tree form is used for adding the partial product in the example, other adding system may be used. Also in the example, the multiplier $k_1$ is four bits and the number of adding steps may be relatively small. However, it is clear that if the multiplier $k_1$ is eight bits or more the number of adding steps increases and effect of pipeline processing further increases. Although an example of usual parallel multiplying circuit is disclosed in Fig. 4, an encoder using Booth algorithm may be used to form the partial product.

In the multiplying circuit 25, since pipeline processing of one step is executed the delay circuit of one step among the unit delay circuits 54, 55 will do, but the pipeline processing of two steps is necessary in the multiplying circuit 26. In this case, a unit delay circuit of further step may be inserted between the adder 56 and the adder 23 in Fig. 4. In this constitution, the operation cycle time can be made 1/3.

Comparing the embodiment of the invention with the IIR digital filter shown in Fig. 2, the fixed delay is increased by five steps in the embodiment thereby strictly saying the system function becomes multiplication of $Z^{-5}$ term to expression (2). However, both are equivalent in the essential characteristics and increase of the fixed delay produces no particular problem in processing of color video signal.

In the embodiment of the invention, processing corresponding to the denominator of the system function is previously executed and then processing corresponding to the numerator is executed. However, processing corresponding to the numerator may be previously done and then processing corresponding to the denominator be done. Although the numerator is constituted as product of polynomial of second order in the embodiment, polynomial of the numerator may be expanded into polynomial of fourth order.

In the embodiment of Fig. 3, an adder of two-input type is only used. However, if an adder of three-input type is used as shown in Fig. 2, output of the delay circuit 22 may be connected to input of the delay circuit 24 and be fed back from the joint of these delay circuits 22, 24 through the multiplying circuit 25 in pipeline processing to other input terminal of the adder 21 at input side of the delay circuit 22. In this case, a separate FIR filter need not be constituted in series to the circuit constituting the IIR filter, but the delay circuits 22, 24 to constitute the IIR filter may be also used as an FIR filter.

According to the invention, since the system function H(Z) is transformed and $Z^{-1}$ term is eliminated from the denominator, pipeline processing of one step and two steps may be applied to the multiplying circuits 25 and 26 in the feedback loop. If the pipeline processing of one step is executed, the operation stage is divided into two steps and the operation cycle time can be made 1/2. Likewise, if the pipeline processing of n steps is executed, the operation stage is divided into $(n+1)$ steps and the cycle time can be made $1/(n+1)$. since the system function H(Z) is transformed, the multiplying circuits 25 and 26 in the feedback loop have double word length in comparison to the multiplying circuits 14 and 15 in the feedback loop before the transformation of the system function H(Z). If word length of either one of multiplier and multiplicand is not changed, for example, when multiplication by addition of tree form is executed, double word length of either one of multiplier and multiplicand does not cause the processing time to increase to double value. Consequently, an IIR digital filter to be used for high-speed digital signal such as video signal can be attained using an operation element of relatively low speed and small power such as CMOS, thereby an IIR digital filter with small consumption power and compact structure can be realized in high-density assembling.

## Claims

1. A digital filter of the infinite impulse response type for filtering a digital signal of a predetermined sampling frequency and having a system function which has a numerator and a denominator and which includes a first order term at least in its denominator, **characterized** in that

   a) firstly the numerator and the denominator of the desired system function are both multiplied by the same polynominal expression such that first order terms are eliminated in the denominator of the new system function,

   b) the new system function consists of a product of two polynominal factors in the numerator and a polynominal factor in the denominator,

   c) the afore said three factors are individually processed in a pipeline structure of three filter elements (20 to 26; 27 to 34; 35 to 41) in which

   d) the filter element (20 to 26) for the denominator includes a first series connection of two delay circuits (22,24) to both of which are supplied feedback signals of the said filter element (20 to 26) via multiplying circuits (26,25),

   e) both filter elements (27 to 34; 35 to 41) for the numerator include each a second series connection of two delay circuits (27,30;36,37) being connected with their outputs via multiplying circuits (33; 38, 41) to respective inputs of two series connected adders (28,32;35,40) having interposed between them a further delay circuit (31;39), whereby the adder (28;35) whose output is connected to the input side of the last said delay circuit (31;39) is connected with its second input to the input of the first delay circuit (27;36) of the said second series connection of delay circuits (27,30;36,37); and

   f) one of the filter elements (i.e. 27 to 34) for the numerator includes a further delay circuit (34) at its output side.

2. A digital filter according to claim 1, wherein said system function has a second order polynomial expression in its denominator, said second order polynomial expression being expressed as follows,

$$H(Z) = \frac{h(Z)}{1 - b_1 Z^{-1} - b_2 Z^{-2}}$$

EP 0 146 963 B1

and the polynomial expression multiplied to both the denominator and the numerator is $(1 - b_2 Z^{-2}) + b_1 Z^{-1}$.

## Patentansprüche

1. Digitalfilter vom IIR-Typ zum Filtern eines mit einer bestimmten Abtastfrequenz auftretenden digitalen Signals, wobei das Filter einer Systemfunktion genügt, die einen Zähler und einen Nenner aufweist und die zumindest in ihrem Nenner einen Term erster Ordnung enthält,
**dadurch gekennzeichnet,**
a) daß zunächst der Zähler und der Nenner der gewünschten Systemfunktion jeweils mit demselben Polynomausdruck multipliziert werden, derart, daß Terme erster Ordnung im Nenner der neuen Systemfunktion eliminiert sind,
b) daß die neue Systemfunktion aus einem Produkt zweier Polynomfaktoren im Zähler und einem Polynomfaktor im Nenner besteht,
c) daß die zuvor genannten drei Faktoren individuell in einer Pipeline-Struktur aus drei Filterelementen (20 bis 26; 27 bis 34; 35 bis 41) verarbeitet werden, von denen
d) das Filterelement (20 bis 26) für den Nenner eine erste Reihenschaltung aus zwei Verzögerungsschaltungen (22,24) umfaßt, denen jeweils Rückkopplungssignale des betreffenden Filterelements (20 bis 26) über Multiplizierschaltungen (26, 25) zugeführt sind,
e) die beiden Filterelemente (27 bis 34; 35 bis 41) für den Zähler jeweils eine zweite Reihenschaltung aus zwei Verzögerungsschaltungen (27, 30; 36, 37) umfassen, die mit ihren Ausgängen über Multiplizierschaltungen (33; 38, 41) mit entsprechenden Eingängen zweier in Reihe geschalteter Addierer (28, 32; 35, 40) verbunden sind, zwischen denen jeweils eine weitere Verzögerungsschaltung (31; 39) eingefügt ist, wobei der Addierer (28;35), dessen Ausgang mit der Eingangsseite der jeweiligen letztgenannten Verzögerungsschaltung (31; 39) verbunden ist, mit seinem zweiten Eingang mit dem Eingang der ersten Verzögerungsschaltung (27;36) der jeweiligen zweiten Reihenschaltung von Verzögerungsschaltungen (27, 30; 36, 37) verbunden ist, und
f) eines der Filterelemente (das heißt 27 bis 34) für den Zähler eine weitere Verzögerungsschaltung (34) auf seiner Ausgangsseite aufweist.

2. Digitalfilter nach Anspruch 1, wobei die Systemfunktion in ihrem Nenner einen Polynomausdruck zweiter Ordnung aufweist, der durch die Beziehung

$$H(Z) = \frac{h(Z)}{1 - b_1 Z^{-1} - b_2 Z^{-2}}$$

gegeben ist,
und wobei der Polynomausdruck, mit dem der Nenner und der Zähler multipliziert werden, durch $(1 - b_2 Z^{-2}) + b_1 Z^{-1}$ gegeben ist.

## Revendications

1. Un filtre numérique du type à réponse impulsionnelle infinie, prévu pour filtrer un signal numérique d'une fréquence d'échantillonnage prédéterminée, et ayant une fonction de transfert de système qui a un numérateur et un dénominateur et qui contient un terme du premier degré au moins dans son dénominateur, caractérisé en ce que :
a) premièrement, on multiplie le numérateur et le dénominateur de la fonction de transfert de système désirée par la même expression polynominale, de façon que des termes du premier degré soient éliminés dans le dénominateur de la nouvelle fonction de transfert de système,
b) la nouvelle fonction de transfert de système consiste en un produit de deux facteurs polynomiaux au numérateur, et en un facteur polynomial au dénominateur,
c) les trois facteurs précités sont traités individuellement dans une structure pipeline de trois éléments de filtre (20 à 26; 27 à 34; 35 à 41), dans laquelle :
d) l'élément de filtre (20 à 26) pour le dénominateur comprend une première connexion en série de

6

deux circuits de retard (22, 24) auxquels sont appliqués des signaux de rétroaction de l'élément de filtre (20 à 26), par l'intermédiaire de circuits multiplieurs (26, 25),

e) les deux éléments de filtre (27 à 34; 35 à 41) pour le numérateur comprennent chacun une seconde connexion en série de deux circuits de retard (27, 30; 36, 37) dont les sorties sont connectées par l'intermédiaire de circuits multiplieurs (33; 38, 41) à des entrées respectives de deux additionneurs connectés en série (28, 32; 35, 40) entre lesquels est interposé un circuit de retard supplémentaire (31; 39), grâce à quoi l'additionneur (28; 35) dont la sortie est connectée au côté d'entrée du circuit de retard mentionné en dernier (31; 39) est connecté par sa seconde entrée à l'entrée du premier circuit de retard (27; 36) de la seconde connexion en série de circuits de retard (27, 30; 36, 37); et

f) l'un des éléments de filtre (c'est-à-dire 27 à 34) pour le numérateur comprend un circuit de retard supplémentaire (34) du côté de sa sortie.

2. Un filtre numérique selon la revendication 1, dans lequel la fonction de transfert de système présente une expression polynomiale du second degré dans son dénominateur, cette expression polynomiale du second degré est de la forme :

$$H(Z) = \frac{h(Z)}{1 - b_1 Z^{-1} - b_2 Z^{-2}}$$

et l'expression polynomiale par laquelle on multiplie à la fois le dénominateur et le numérateur est : $(1 - b_2 Z^{-2}) + b_1 Z^{-1}$.

# FIG. 1

# FIG. 2

# FIG. 3

# FIG. 4